# EUROPEAN PATENT APPLICATION

(11) **EP 2 003 775 A2**
(43) Date of publication of application: **17.12.2008**
(21) Application number: 07740050.5
(22) Date of filing: 28.03.2007
(51) Int. Cl.: H03H 9/17, H01L 41/09, H01L 41/18, H03H 9/54, H03H 9/58

(54) **PIEZOELECTRIC RESONATOR AND PIEZOELECTRIC FILTER**

(30) Priority: 05.04.2006 JP 2006104195
(71) Applicant: Murata Manufacturing Co. Ltd., Nagaokakyo-shi, Kyoto 617-8555 (JP)
(72) Inventor: UMEDA, Keiichi, Nagaokakyo-shi, Kyoto 617-8555 (JP); MIYAKE, Takashi, Nagaokakyo-shi, Kyoto 617-8555 (JP)
(74) Representative: Zimmermann, Tankred Klaus
(86) International application number: PCT/JP2007/056612
(87) International publication number: WO 2007/119556

(57) **Abstract**

A piezoelectric resonator is obtained that is capable of having a reduced size and thickness thereof and that is less prone to having a spurious component occurring in a mode at which it propagates in a piezoelectric thin film at a range higher than a resonant frequency.

A piezoelectric resonator includes a laminated thin film having a first thin film portion supported by a substrate 2 and a second thin film portion separated from a first main surface of the substrate and acoustically isolated. The second thin film portion of the laminated thin film includes a piezoelectric thin film 5, a first electrode 12 disposed on the upper surface of the piezoelectric thin film, and a second electrode 13 disposed on the lower surface of the piezoelectric thin film and being larger and thicker than the first electrode. The piezoelectric resonator further includes a mass adding film 11 disposed around the first electrode 12 and on at least one part of a region outside the periphery of a piezoelectric vibrating portion where the first and second electrodes 12 and 13 overlap each other with the piezoelectric thin film 5 disposed therebetween. The second electrode 13 is formed, in plan view, so as to extend beyond the piezoelectric vibrating portion to a region at which the mass adding film 11 is disposed.

## Description

### Technical Field

The present invention relates to a piezoelectric resonator and piezoelectric filter fabricated using a piezoelectric thin film, and more specifically, to a piezoelectric resonator and piezoelectric filter that have a configuration in which a piezoelectric vibrating portion including a piezoelectric thin film is arranged while being separated from a substrate.

### Background Art

Piezoelectric resonators and piezoelectric filters are known that include a thin piezoelectric vibrating portion fabricated using a piezoelectric thin film.

For example, Patent Document 1 mentioned below discloses a piezoelectric filter illustrated in Fig. 25. For a piezoelectric filter 501, recesses 502a and 502b are formed on the upper surface of a support substrate 502. In a region where the recess 502a is formed, a first piezoelectric resonator 506 including a piezoelectric thin film 503, an upper electrode 504, and a lower electrode 505 is formed above the recess 502a.

Similarly, a piezoelectric resonator 509 including the piezoelectric thin film 503, an upper electrode 507, and a lower electrode 508 is also formed above the recess 502b.

Here, the piezoelectric resonators 506 and 509 are electrically connected to each other such that the piezoelectric resonator 506 is a series arm resonator and the piezoelectric resonator 509 is a parallel arm resonator, and the piezoelectric filter 501 having a ladder circuit configuration is formed. To provide a difference between the resonant frequency of the series arm resonator and that of the parallel arm resonator, the lower electrode 505 of the piezoelectric resonator 506 and the lower electrode 508 of the other piezoelectric resonator 509 have different thicknesses.

Patent Document 2 mentioned below discloses an energy-trap piezoelectric resonator utilizing the thickness longitudinal vibration mode. For this piezoelectric resonator, in the part where an upper electrode and a lower electrode overlap each other with a piezoelectric substrate disposed therebetween, an energy-trap piezoelectric vibrating portion utilizing the thickness longitudinal vibration mode is fabricated. A mass adding film having the mass adding effect is disposed at the outer area of either the upper electrode or the lower electrode. The mass adding film adds mass to the surrounding area of the piezoelectric vibrating portion. This enables the thickness longitudinal vibration mode to be effectively trapped in the piezoelectric vibrating portion.
Patent Document 1: Japanese Unexamined Patent Application Publication No. 2002-299980
Patent Document 2: WO99/37023

### Disclosure of Invention

The piezoelectric filter 501 described in Patent Document 1 is fabricated using the piezoelectric thin film 503 having a small thickness. Therefore, compared with when a piezoelectric plate having a relatively large thickness is used, the resonant frequency of each of the piezoelectric resonators 506 and 509 can be increased. That is, the piezoelectric filter 501 usable in a higher frequency range can be fabricated utilizing the thickness longitudinal vibration mode.

However, a spurious component caused by another mode, such as a Lamb wave propagating in the direction of the plane of the piezoelectric thin film 503, other than the thickness longitudinal vibration mode, may appear, and favorable resonant characteristics and filter characteristics may not be obtained.

In light of present circumstances in the related-art technologies described above, it is an object of the present invention to provide a piezoelectric resonator and piezoelectric filter less prone to having deterioration in characteristics resulting from a spurious component propagating in the direction of the plane of a piezoelectric thin film, the piezoelectric resonator and piezoelectric filter being capable of using a relatively thin piezoelectric thin film and being usable in a higher frequency range.

According to the present invention, a piezoelectric resonator includes a substrate including first and second main surfaces and a laminated thin film including a first thin film portion and a second thin film portion is provided. The first thin film portion is fixed on the first main surface of the substrate and supported by the substrate. The second thin film portion is separated from the first main surface of the substrate and acoustically isolated. The second thin film portion of the laminated thin film includes a piezoelectric thin film, a first electrode disposed on one main surface of the piezoelectric thin film, and a second electrode disposed on another main surface of the piezoelectric thin film and being larger than the first electrode, and a part where the first and second electrodes overlap each other with the piezoelectric thin film disposed therebetween constitutes a piezoelectric vibrating portion. The piezoelectric resonator further includes a mass adding film disposed around the first electrode and on at least one part of an outer region linked to a periphery of the piezoelectric vibrating portion. The second electrode is formed, in plan view, so as to extend beyond the piezoelectric vibrating portion to a region at which the mass adding film is disposed.

The piezoelectric resonator according to a particular aspect of the present invention may further includes a step forming film disposed on the first electrode and disposed within the periphery of the piezoelectric vibrating portion with a gap. In this case, because, due to the presence of the step forming film on the piezoelectric vibrating portion, the outer edge of the step forming film forms a step, a spurious component occurring in a range smaller than the resonant frequency can be suppressed.

In the piezoelectric resonator according to another particular aspect of the present invention, the first electrode and the second electrode may have different film thicknesses. In this case, either the first electrode or the second electrode may have a larger film thickness. In another particular aspect of the present invention, the second electrode may have a film thickness larger than that of the first electrode. That is, in the plane having no mass adding film, the mass adding effect produced by the second electrode can be provided. Therefore, because, in a region outside the piezoelectric vibrating portion, mass is added from both surfaces, a spurious component caused by vibration occurring along the direction of the plane of the piezoelectric thin film can be effectively suppressed.

In a piezoelectric filter according to the present invention, a plurality of piezoelectric resonators are fabricated on the same substrate, and the plurality of piezoelectric resonators are electrically connected together and constitute a filter circuit. Therefore, because each piezoelectric resonator is fabricated using the piezoelectric thin film, the piezoelectric filter can be used in a higher frequency range and have a reduced thickness. Additionally, according to the present invention, because the mass adding film is provided around the first electrode and the second electrode is larger, a spurious component can be effectively suppressed by the use of the mass adding effect produced by the mass adding film and the second electrode. Therefore, favorable filter characteristics are obtainable.

In the piezoelectric filter according to a particular aspect of the present invention, at least one piezoelectric resonator of the plurality of piezoelectric resonators may be fabricated differently from the other piezoelectric resonators. Therefore, various filter characteristics are obtainable by combining resonant characteristics of piezoelectric resonators having different characteristics.

In the piezoelectric filter according to another particular aspect of the present invention, the second electrode of the at least one piezoelectric resonator may have a film thickness different from that of the second electrode of each of the other piezoelectric resonators, thereby causing a resonant frequency of the at least one piezoelectric resonator to differ from a resonant frequency of each of the other piezoelectric resonators. Therefore, a ladder filter can be fabricated by using one of at least two kinds of piezoelectric resonators including second electrodes having different thicknesses as, for example, a series arm resonator and the other as, for example, a parallel arm resonator. In addition to such a ladder circuit, various filters can be fabricated by connecting at least two kinds of piezoelectric resonators having different resonant frequencies described above. Thus, various filter characteristics can be realized.

In the piezoelectric filter according to still another particular aspect of the present invention, in the at least one piezoelectric resonator of the plurality of piezoelectric resonators, the first electrode and the second electrode may have different film thicknesses. That is, the film thickness of the first electrode and that of the second electrode may be different.

In the piezoelectric filter according to yet another particular aspect of the present invention, in the at least one piezoelectric resonator of the plurality of piezoelectric resonators, the second electrode may have a film thickness larger than that of the first electrode. In this case, the mass adding action produced by the second electrode can be enhanced by its larger film thickness, so a spurious component can be suppressed more effectively.

### (Advantages)

In the piezoelectric resonator according to the present invention, the energy-trap piezoelectric vibrating portion is fabricated. Therefore, because the piezoelectric vibrating portion is fabricated using the relatively thin piezoelectric thin film, the piezoelectric resonator can have a reduced thickness and be used in a higher frequency range. Additionally, the mass adding film is disposed around the first electrode having a smaller size, and mass is added to the surrounding area of the piezoelectric vibrating portion by this mass adding film. On the other hand, the second electrode is larger than the first electrode, and, in plan view, it is formed so as to extend beyond the piezoelectric vibrating portion to a region where the mass adding film is disposed. Therefore, mass is added to the piezoelectric thin film by both the mass adding film and the second electrode portion facing the mass adding film. Accordingly, a spurious component caused by vibration propagating in the direction of the plane of the piezoelectric thin film can be effectively suppressed, so favorable resonant characteristics having a significantly small spurious component are obtainable.

### Brief Description of Drawings

Fig. 1 is a schematic front cross-sectional view of a piezoelectric filter according to a first embodiment of the present invention.
Figs. 2 are a schematic plan view of a part where one piezoelectric resonator of the piezoelectric filter according to the first embodiment is disposed and a schematic, partially broken, front, cross-sectional view of the piezoelectric resonator.
Fig. 3 is a schematic front cross-sectional view of a piezoelectric filter according to a first comparative example.
Figs. 4(a) and 4(b) are Smith charts that illustrate resonant characteristics of one piezoelectric resonator and those of the other piezoelectric resonator of the piezoelectric filter according to the first comparative example shown in Fig. 3, respectively.
Fig. 5 is a Smith chart that illustrates resonant characteristics of one piezoelectric resonator of the piezoelectric filter according to the first comparative example when the film thickness of a mass adding film of the piezoelectric resonator is increased to 600 nm.
Fig. 6 is a schematic front cross-sectional view of a piezoelectric filter according to a second comparative example.
Figs. 7(a) and 7(b) are impedance Smith charts that illustrate resonant characteristics of one piezoelectric resonator and those of the other piezoelectric resonator of the piezoelectric filter according to the second comparative example, respectively.
Fig. 8 is an impedance Smith chart that illustrates resonant characteristics of one piezoelectric resonator of the piezoelectric filter according to the second comparative example when the thickness of a mass adding film of the piezoelectric resonator is increased.
Figs. 9(a) and 9(b) are impedance Smith charts that illustrate resonant characteristics of one piezoelectric resonator and those of the other piezoelectric resonator of the piezoelectric filter according to the first embodiment of the present invention, respectively.
Figs. 10(a) to 10(c) are impedance Smith charts that illustrate resonant characteristics of one piezoelectric resonator of the piezoelectric filter according to the first embodiment when the film thickness of a mass adding film of the piezoelectric resonator is changed to 240 nm, 260 nm, and 320 nm, respectively.
Figs. 11(a) and 11(b) are impedance Smith charts that illustrate resonant characteristics of one piezoelectric resonator of the piezoelectric filter according to the first embodiment when the film thickness of the mass adding film of the piezoelectric resonator is changed to 420 nm and 440 nm, respectively.
Fig. 12 illustrates a relationship between the thickness of a piezoelectric thin film made of aluminum nitride (AlN) and the electromechanical coupling coefficient kₜ²=π²/4×fs(fp-fs)/fp×100 (%) [where fs is the resonant frequency and fp is the anti-resonant frequency] when various metallic electrodes are formed.
Fig. 13 is an impedance Smith chart that illustrates resonant characteristics of one piezoelectric resonator of a piezoelectric filter according to a modification example in which an electrode material is a material predominantly made of platinum (Pt).
Fig. 14(a) to 14(c) are illustrations for describing a method of making a piezoelectric filter according to a modification example of the present invention and are a schematic plan view that illustrates a main part of one piezoelectric resonator of an obtained piezoelectric filter, a cross-sectional view taken along the line C-C in Fig. 14(a), and a cross-sectional view taken along the line D-D therein, respectively.
Figs. 15(a) to 15(d) are schematic front cross-sectional view for describing steps of making the piezoelectric filter according to the modification example illustrated in Figs. 14.
Figs. 16(a) to 16(d) are schematic front cross-sectional view for describing steps of making the piezoelectric filter according to the modification example illustrated in Figs. 14.
Figs. 17(a) and 17(b) are schematic front cross-sectional view for describing steps of making the piezoelectric filter according to the modification example illustrated in Figs. 14.
Fig. 18 is a schematic front cross-sectional view of a piezoelectric filter according to a second embodiment of the present invention.
Fig. 19 is a circuit diagram that illustrates a lattice circuit as one example of circuit configuration of a piezoelectric filter to which the present invention is applied.
Fig. 20 is a circuit diagram that illustrates a ladder circuit as one example of circuit configuration of a piezoelectric filter to which the present invention is applied.
Fig. 21 is a schematic front cross-sectional view of a piezoelectric filter according to a third embodiment of the present invention.
Figs. 22(a) and 22(b) are impedance Smith charts that illustrate resonant characteristics of one piezoelectric resonator and those of the other piezoelectric resonator of the piezoelectric filter according to the third embodiment, respectively.
Fig. 23 is a schematic front cross-sectional view for describing a piezoelectric filter according to still another modification example of the present invention.
Fig. 24 is a schematic front cross-sectional view for describing a piezoelectric filter according to yet another modification example of the present invention.
Fig. 25 is a schematic front cross-sectional view for describing a piezoelectric resonator according to a modification example of the present invention.
Fig. 26 is a schematic front cross-sectional view that illustrates a piezoelectric resonator according to another modification example of the present invention.
Fig. 27 is a schematic front cross-sectional view that illustrates a piezoelectric resonator according to another modification example of the present invention.
Fig. 28 is a schematic front cross-sectional view that illustrates a piezoelectric resonator according to another modification example of the present invention.
Fig. 29 is a schematic plan view of a piezoelectric resonator according to a different modification example of the present invention.
Fig. 30 is a cross-sectional view taken along the line X1-X1 in Fig. 29.
Fig. 31 is a cross-sectional view taken along the line X2-X2 in Fig. 29.
Fig. 32 is a schematic plan view for describing a piezoelectric resonator according to still another modification example of the present invention.
Fig. 33 is a schematic front cross-sectional view that illustrates a piezoelectric resonator according to another modification example of the present invention.
Fig. 34 is a schematic side cross-sectional view of the modification example illustrated in Fig. 34.
Fig. 35 is a schematic front cross-sectional view that illustrates a piezoelectric resonator according to another modification example of the present invention.
Fig. 36 is a schematic side cross-sectional view of the modification example illustrated in Fig. 35.

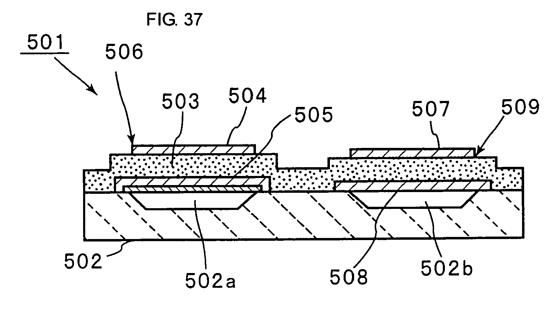

Fig. 37 is a schematic front cross-sectional view that illustrates one example of a piezoelectric filter in the related art.

### Reference Numerals

- 1: piezoelectric filter
- 2: substrate
- 2a: upper surface
- 2b: lower surface
- 3: piezoelectric resonator
- 3A to 3E: piezoelectric resonator
- 4: piezoelectric resonator
- 4A to 4E: piezoelectric resonator
- 5: piezoelectric thin film
- 6: cavity
- 7: cavity
- 8: upper electrode
- 9: lower electrode
- 11: mass adding film
- 12: upper electrode
- 13: lower electrode
- 10, 14: frequency adjustment film

### Best Modes for Carrying Out the Invention

The present invention will be clarified below by describing specific embodiments of the present invention with reference to the drawings.

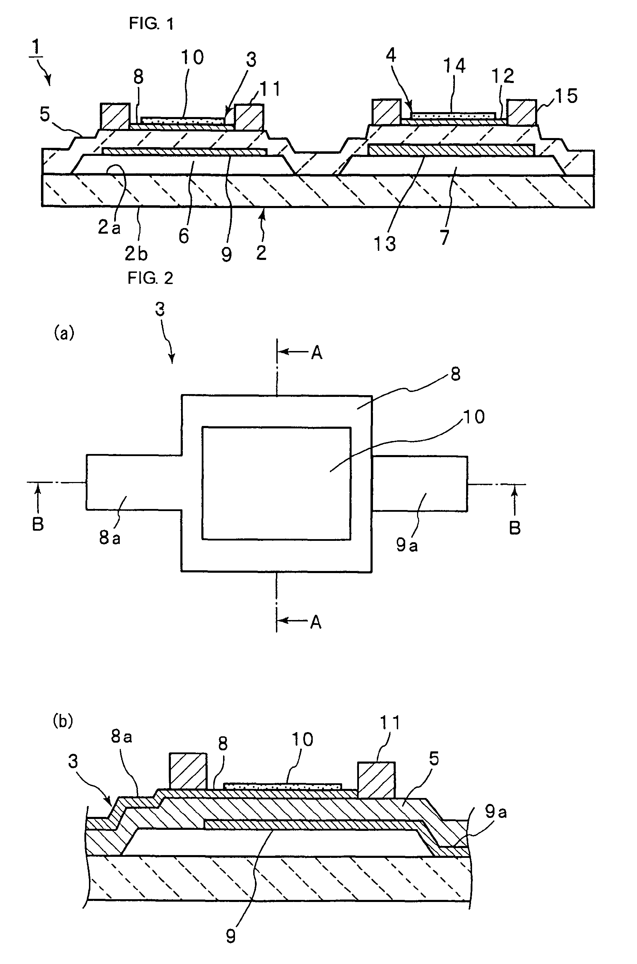

Fig. 1 is a front cross-sectional view of a piezoelectric filter according to a first embodiment of the present invention. A piezoelectric filter 1 includes a substrate 2. The substrate 2 includes an upper surface 2a as a first main surface and a lower surface 2b as a second main surface. The substrate 2 is provided to support a piezoelectric resonator described later. Thus, the substrate 2 can be made of an insulating material, such as suitable insulating ceramics or insulating resin.

In the present embodiment, the substrate 2 is composed of a Si-based substrate.

Piezoelectric resonators 3 and 4 are arranged above the upper surface 2a of the substrate 2. Each of the piezoelectric resonators 3 and 4 is a piezoelectric thin-film resonator using a piezoelectric thin film described later.

That is, a piezoelectric thin film 5 is arranged above the upper surface 2a of the substrate 2. In the part where the piezoelectric resonators 3 and 4 are formed, the piezoelectric thin film 5 is separated from and disposed above the upper surface 2a with cavities 6 and 7 disposed therebetween.

The piezoelectric thin film 5 is fixed on the upper surface 2a of the substrate 2 around the part where the cavities 6 and 7 are formed.

In the part where the piezoelectric resonator 3 is formed, an upper electrode 8 is formed on an upper surface of the piezoelectric thin film 5, and a lower electrode 9 is formed on a lower surface of the piezoelectric thin film 5 so as to overlap the upper electrode 8 with the piezoelectric thin film 5 disposed therebetween. The lower electrode 9 is larger than the upper electrode 8. The upper electrode 8 corresponds to a first electrode in the present invention, and the lower electrode 9 corresponds to a second electrode. In the piezoelectric resonator 3, the upper electrode 8 and the lower electrode 9 are laminated on the top and the bottom of the piezoelectric thin film 5, respectively. Such a laminated thin film forms the piezoelectric resonator 3 and the piezoelectric resonator 4, which is described later.

The laminated thin film includes a first thin-film portion fixed on the upper surface 2a of the substrate 2 and a second thin-film portion. The second thin-film portion is separated from and acoustically isolated from the upper surface 2a of the substrate 2. This second thin-film portion constitutes the piezoelectric resonator 3 and the piezoelectric resonator 4, which is described later.

The second thin-film portion, in which the upper electrode 8 and the lower electrode 9 overlap each other with the piezoelectric thin film 5 disposed therebetween, constitutes a piezoelectric vibrating portion. In the present embodiment, the piezoelectric thin film 5 is made of aluminum nitride (AlN), and the direction of the polarization axis thereof is the thickness direction. Therefore, resonant characteristics utilizing the thickness longitudinal vibration mode are obtainable by the application of alternating voltage from the upper electrode 8 and the lower electrode 9. In this case, the part where the upper electrode 8 and the lower electrode 9 overlap each other with the piezoelectric thin film 5 disposed therebetween is an energy-trap piezoelectric vibrating portion driven by the application of the alternating voltage. The piezoelectric vibrating portion is formed using the piezoelectric thin film 5 having a thickness of the order of 0.1 µm to 10 µm. That is, because it is formed using a laminated thin film, the piezoelectric resonator can be used in a higher frequency range, compared with a piezoelectric resonator using a piezoelectric substrate thicker than 10 µm and utilizing the thickness longitudinal vibration mode.

Each of the upper electrode 8 and the lower electrode 9 is made of a suitable conductive material. In the present embodiment, the upper electrode 8 is composed of a laminated metallic film including an Al electrode layer as the main layer and an electrode layer made of titanium (Ti) as the primer layer laminated therebelow.

In the present embodiment, the lower electrode 9 has a structure in which Pt, Ti, Al, and Ti layers are laminated. In this case, the lower electrode 9 is arranged such that the Pt layer is situated outermost.

That is, the lower electrode 9 includes the Al layer as the principal part, the Ti layers formed on both surfaces of the Al layer, and the Pt layer disposed outermost.

In the piezoelectric vibrating portion, a frequency adjustment film 10 is disposed above the upper electrode 8. The frequency adjustment film 10 is provided to add mass onto the upper electrode 8 and adjust the resonant frequency in the piezoelectric vibrating portion. The frequency adjustment film 10 may not necessarily be provided.

It is noted that utilizing the mass adding action produced by the frequency adjustment film 10, that is, selecting the thickness or material of the frequency adjustment film 10 enables the resonant frequency of the piezoelectric resonator 3 to be adjusted to a desired resonant frequency with high precision.

Additionally, in the present embodiment, the frequency adjustment film 10 is arranged within the perimeter of the upper electrode 8 as the first electrode with a gap. The outer edge of this frequency adjustment film forms a step above the piezoelectric vibrating portion. That is, a step formed by the outer edge of the frequency adjustment film 10 is present between the upper surface of the upper electrode 8 and the upper surface of the frequency adjustment film 10. Owing to the formation of the step, the effect of reducing a spurious component in a frequency range below the resonant frequency is also obtainable. In other words, in the present invention, the frequency adjustment film 10 also functions as a step forming film for reducing the spurious component.

Preferably, the size of the step may be adjusted by reduction in the thickness of a part adjacent to the outer edge of the frequency adjustment film 10 so that the spurious component can be reduced more effectively. In this case, more favorable filter characteristics are obtainable.

In the present embodiment, the frequency adjustment film 10 is made of silicon dioxide (SiO₂). Preferably, the frequency adjustment film 10 may be made of the same material as a mass adding film 11, which is described later. In this case, the number of kinds of materials to be prepared can be reduced.

In the region outside the piezoelectric vibrating portion, the mass adding film 11 is arranged on the upper surface of the piezoelectric thin film 5. The mass adding film 11 is disposed on a part of an outer region linked to the periphery of the piezoelectric vibrating portion. In the present embodiment, the mass adding film 11 has an annular shape so as to surround the outer edge of the piezoelectric vibrating portion. The provision of the mass adding film 11 enables a spurious component for the utilized thickness longitudinal vibration mode, the spurious component being caused by vibration occurring along the direction of the plane of the piezoelectric thin film 5, can be effectively suppressed.

The material of the mass adding film 11 is not particularly limited. In the present embodiment, the mass adding film 11 is made of SiO₂.

In the present embodiment, the lower electrode 9 as the second electrode extends to a region under the region where the mass adding film 11 is formed. In other words, the second electrode 9 extends to a region outside the piezoelectric vibrating portion and, in plan view, extends beyond the piezoelectric vibrating portion to the region where the mass adding film 11 is formed. Because the lower electrode 9 as the second electrode extends to the region where the mass adding film 11 is formed outside the piezoelectric vibrating portion, in the present embodiment, the spurious component can also be effectively suppressed by the mass adding action of the lower electrode 9 in the part where the lower electrode 9 extends to the region where the mass adding film 11 is disposed. The effect of the mass adding action produced by the mass adding film 11 and the lower electrode 9 as the second electrode is described later based on experimental examples.

Also for the piezoelectric resonator 4, as in the case of the piezoelectric resonator 3, an upper electrode 12 is disposed on the upper surface of the piezoelectric thin film 5, and a lower electrode 13 is disposed on the lower surface thereof. The lower electrode 13 as the second electrode is larger than the upper electrode 12 as the first electrode.

A frequency adjustment film 14 is formed above the upper electrode 12. In the region outside the piezoelectric vibrating portion, where the upper electrode 12 and the lower electrode 13 overlap each other, a mass adding film 15 is arranged on the upper surface of the piezoelectric thin film 5 along the surrounding area of the piezoelectric vibrating resistant portion. Also in the piezoelectric resonator 4, the lower electrode 13 extends to the region where the mass adding film 15 is disposed.

It is noted that, in the piezoelectric resonator 4, the lower electrode 13 is thicker than the upper electrode 12.

Therefore, the mass adding action on the piezoelectric thin film 5 by the lower electrode 13 is larger than that by the lower electrode 9 of the piezoelectric resonator 3. Accordingly, the piezoelectric resonators 3 and 4 having different resonant frequencies can be formed, while the same substrate 2 and piezoelectric thin film 5 are used. In other words, the piezoelectric resonator 4 having resonant characteristics different from those of the piezoelectric resonator 3 can be readily formed by making an appropriate choice for the thickness and material of the lower electrode 13 and for the material and thickness of the frequency adjustment film 14. In this case, even when the frequency adjustment film 14 is made using the same material as in the frequency adjustment film 10 and has substantially the same thickness as that of the frequency adjustment film 10, the piezoelectric resonators 3 and 4 having different resonant characteristics can be readily formed by causing the lower electrode 13 to differ from the lower electrode 9.

In the present embodiment, the electrode material of the upper electrode 12 and that of the lower electrode 13 are substantially the same as the electrode material of the upper electrode 8 and that of the lower electrode 9 of the piezoelectric resonator 3, respectively. It is noted that, as in experimental examples described later, the thickness of each of the metallic layers forming the upper electrode 12 and the lower electrode 13 of the piezoelectric resonator 4 is different from the thickness of each of the metallic layers in the piezoelectric resonator 3.

In the piezoelectric filter 1 according to the present embodiment, as described above, the piezoelectric resonators 3 and 4 having different resonant characteristics are disposed on the same substrate 2, and the piezoelectric resonators 3 and 4 are electrically connected to each other at a part that is not shown, thus forming a filter circuit. Examples of such a filter circuit are described later.

Also in the piezoelectric resonator 4, the piezoelectric vibrating portion using the piezoelectric thin film 5 is separated from the substrate 2 with the cavity 7 disposed therebetween.

Such a configuration, in which the piezoelectric vibrating portion of each of the piezoelectric resonators 3 and 4 is separated from the substrate 2 with the cavity 6 or 7 disposed therebetween, can be accomplished by various making methods.

One example can be a method of providing a readily solvent-removable material layer, which is readily removable by solvent, to a part where each of the cavities 6 and 7 is to be formed on the substrate 2, then forming a laminated thin film containing the upper electrodes 8 and 12, the lower electrodes 9 and 13, and the piezoelectric thin film 5, and dissolving and removing the readily solvent-removable material layer using a solvent that is incapable of removing the laminated thin film part but is capable of removing the readily solvent-removable material layer. According to this method, the readily solvent-removable material layer is dissolved and removed by use of a solvent, and the cavities 6 and 7 are finally formed. It is noted that the mass adding films 11 and 15 and the frequency adjustment films 10 and 14 may be formed before the formation of the cavities 6 and 7 or may be formed after the formation of the cavities 6 and 7.

In Fig. 1, the main part of the piezoelectric resonator 3 and the piezoelectric resonator 4 is illustrated with a front cross-sectional view. The upper electrodes 8 and 12 and the lower electrodes 9 and 13 are drawn out of the respective piezoelectric vibrating portions at a cross-sectional part different from that illustrated in Fig. 1. This is described with reference to Figs. 2(a) and 2(b). Fig. 2(a) is a schematic plan view of the part where the piezoelectric resonator 3 is disposed, and Fig. 2(b) is a partially broken, cross-sectional view taken along the line B-B in Fig. 2(a). In Fig. 1, a cross-sectional structure of the piezoelectric resonator 3 taken along the line A-A in Fig. 2(a) is illustrated. As illustrated in Figs. 2(a) and 2(b), in the piezoelectric resonator 3, the upper electrode 8 and the lower electrode 9 are extended so as to reach the outside of the piezoelectric vibrating portion and include electrode connection portions 8a and 9a, respectively. The piezoelectric resonator 3 is electrically connected to another piezoelectric resonator, an external terminal, or other electronic component element though these electrode connection portions 8a and 9a.

Although the plane shape of the piezoelectric vibrating portion illustrated in Fig. 2(a) is a square, it may preferably be a rectangle in order to enable a reduction in the area of a device in layout of the piezoelectric resonator. For example, it is preferable that the plane shape of the electrode of the piezoelectric resonator be a rectangle, in particular, a rectangle having sides in the golden ratio known as 1 to (1+√5)/2 as the ratio of the larger segment to the smaller segment because the area of a filter composed of a plurality of piezoelectric resonators can be readily reduced by use of such a rectangle shape. It is noted that, in the present invention, the plane shape of the piezoelectric vibrating portion, where the lower electrode and the upper electrode overlap each other, can be changed to various shape, in addition to a square and a rectangle, such as a circle, an oval, and a regular polygon other than a square.

Next, the capability to suppress vibration that appears at frequencies higher than the resonant frequency of each of the piezoelectric resonators 3 and 4 and that occurs along the direction of the plane of the piezoelectric thin film 5, for example, spurious Lamb waves is described below based on more specific experimental examples.

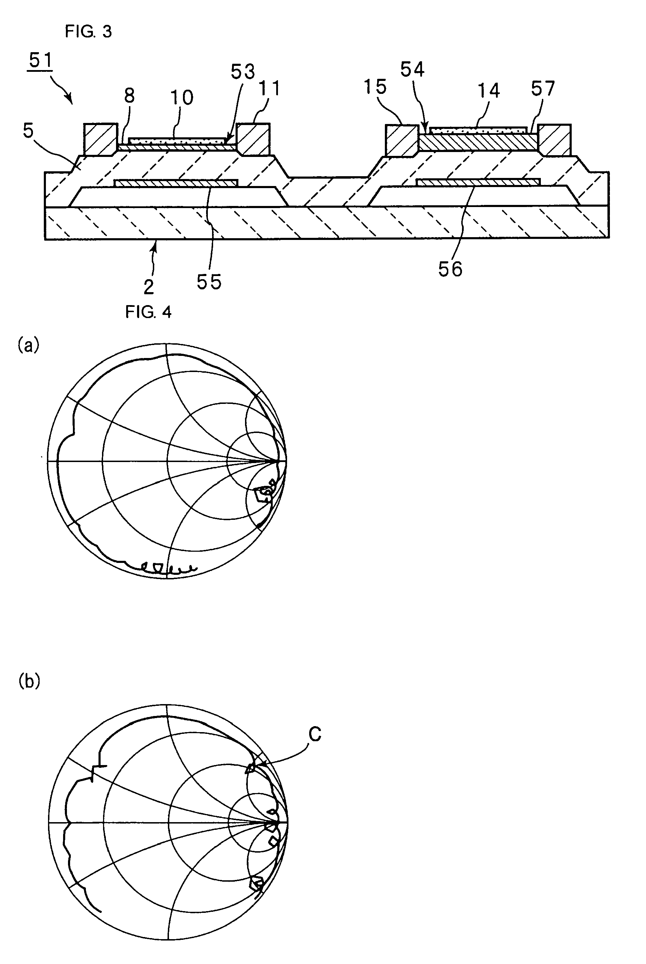

The inventor et al. of the present invention developed a piezoelectric filter 51 of a first comparative example illustrated in Fig. 3 prior to the present invention, although it has not yet been publicly known. The piezoelectric filter 51 has a configuration in which piezoelectric resonators 53 and 54 are fabricated on the same substrate 2 using the piezoelectric thin film 5, as in the case of the piezoelectric filter 1. The piezoelectric filter 51 differs from the piezoelectric filter 1 in that, as illustrated in Fig. 3, the sizes of lower electrodes 55 and 56 as the second electrode are the same as the sizes of the upper electrodes 8 and 12, whereas, in the piezoelectric filter 1, the lower electrodes 9 and 13 as the second electrode extend to regions under the mass adding films 11 and 15, respectively. That is, each of the lower electrodes 55 and 56 is arranged only in the piezoelectric vibrating portion, so it does not extend to a region surrounding the piezoelectric vibrating portion. In contrast to the upper electrode 12 (see Fig. 1), an upper electrode 57 of the piezoelectric resonator 54 has a significantly larger thickness in the present comparative example. The other respects in the piezoelectric filter 51 are substantially the same as in the piezoelectric filter 1, so the detailed description thereof is omitted by attaching the same reference numerals to the same parts as in the piezoelectric filter 1.

The piezoelectric filter 51 was made such that the film thickness and material of each part were set as shown in Table 1 below. In such a way, the piezoelectric filter 51 having a ladder circuit configuration and having a designed resonant frequency of 1883 MHz at the piezoelectric resonator 53 and a designed resonant frequency of 1822 MHz at the piezoelectric resonator 54 was made.

**TABLE 1**

| Film Thickness (nm) | Resonator 53 | Resonator 54 |
|---|---|---|
| Frequency Adjustment Film | 20 | 20 |
| Mass Adding Film | 480 | 480 |
| Upper Electrode (Al/Ti) | 100/10 | 205/10 |
| Piezoelectric Thin Film (AIN) | 2556 | 2556 |
| Lower Electrode (Pt/Ti/Al/Ti) | 10/10/100/10 | 10/10/100/10 |

The resonant characteristics of the piezoelectric resonators 53 and 54 are shown in Figs. 4(a) with impedance Smith charts. They are shown with impedance Smith charts, not impedance-frequency characteristic charts, because the impedance Smith charts can show a state in which a spurious component appears in a higher range more explicitly.

Fig. 4(a) illustrates the resonant characteristics of the piezoelectric resonator 53, and Fig. 4(b) illustrates the resonant characteristics of the piezoelectric resonator 54.

As is obvious from Figs. 4(a) and 4(b), it is found that, for the piezoelectric resonator 54, as indicated by the arrow C, a large spurious component appears in frequencies above the resonant frequency. The reason why such a larger spurious component appears in the piezoelectric resonator 54, compared with the piezoelectric resonator 53, may be that the mass adding action produced by the mass adding film 15 is not sufficient. That is, it is found that, when the piezoelectric filter 51 is designed, when the resonant characteristics of the piezoelectric resonator 53 are optimized, the mass adding action produced by the mass adding film is not sufficient and thus a spurious component appearing in a frequency higher than the above-mentioned frequency cannot be effectively suppressed in the piezoelectric resonator 54.

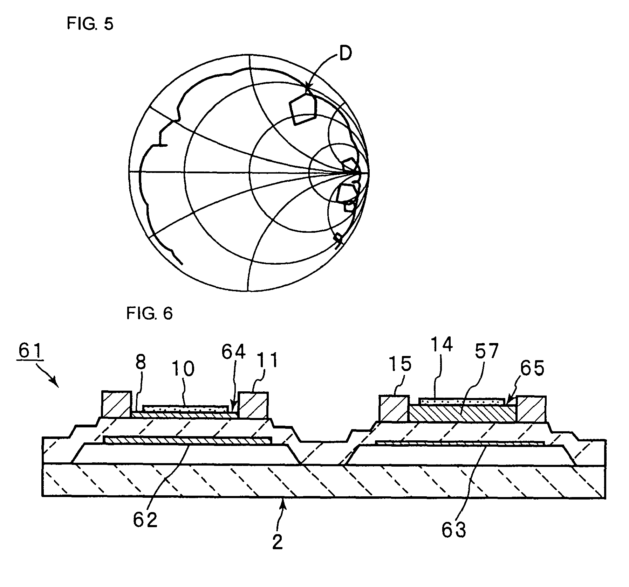

In the present comparative example, the difference in mass at the surrounding area of the piezoelectric vibrating portion in the piezoelectric resonator 53 depends on the difference in thickness between the electrode layers of Al having a density of 2.69 g/m³, i.e., on the electrode layer of 205-100=105 nm. In the case of SiO₂ having a density of 2.2 g/m³, this corresponds to a SiO₂ layer having a thickness of 128 nm. However, it has been shown that, even when the thickness of the mass adding film composed of a SiO₂ film on the piezoelectric resonator 54 is changed from 480 nm to 600 nm, a spurious component D appearing in frequencies higher than the resonant frequency cannot be suppressed, as illustrated in Fig. 5.

The reason may be that, because an increase in the proportion of SiO₂ to the principle material of the vibrating portion, i.e., the piezoelectric thin film made of AlN, results in the difference in Poisson's ratio between the vibrated piezoelectric thin film part and the mass adding film, Lamb waves do not propagate outside the vibrating portion.

As described above, in consideration that a spurious component occurring in frequencies higher than the resonant frequency still cannot be suppressed in the first comparative example illustrated in Fig. 3, the inventor et al. of the present invention studied a piezoelectric filter 61 according to a second comparative example illustrated in Fig. 6.

The piezoelectric filter 61 illustrated in Fig. 6 differs from the piezoelectric filter 51 illustrated in Fig. 3 in that lower electrodes 62 and 63 as the second electrode in piezoelectric resonators 64 and 65, respectively, extend to the outside of the respective piezoelectric vibrating portions. As for the other respects, the piezoelectric filter 61 is substantially the same as in the piezoelectric filter 51.

**TABLE 2**

| Film Thickness (nm) | Resonator 64 | Resonator 65 |
|---|---|---|
| Frequency Adjustment Film | 20 | 20 |
| Mass Adding Film | 320 | 320 |
| Upper Electrode (Al/Ti) | 100/10 | 205/10 |
| Piezoelectric Thin Film (AIN) | 2556 | 2556 |
| Lower Electrode (Pt/Ti/Al/Ti) | 10/10/100/10 | 10/10/100/10 |

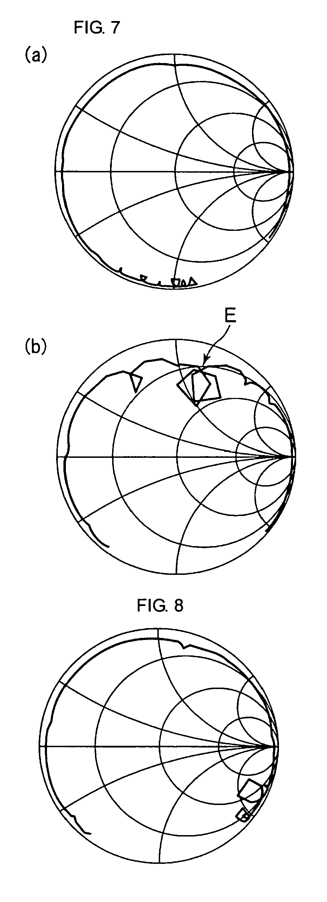

The piezoelectric filter 61 was made such that the film thickness and material of each part were set as shown in Table 2 below and the other respects were substantially the same as in the piezoelectric filter 51 of the first comparative example. The resonant characteristics of the piezoelectric resonators 64 and 65 of the piezoelectric filter 61 are illustrated in Figs. 7(a) and 7(b), respectively.

As is obvious from Fig. 7(b), it is found that, in the piezoelectric resonator 65, as indicated by the arrow E, a spurious component appears in frequencies higher than the resonant frequency and the spurious component is not suppressed.

The reason why the resonant characteristics of the piezoelectric resonator 65 in the piezoelectric resonant filter device 61 are not sufficient is that mass addition corresponding to the piezoelectric resonator 65 is not performed. Therefore, as in the case of the piezoelectric filter 51, the resonant characteristics of the piezoelectric resonator 65 occurring when the thickness of the mass adding film 15 made of SiO₂ is increased from 320 µm to 440 nm are shown in Fig. 8.

As is obvious from Fig. 8, it is found that the increase in the thickness of the mass adding film to 400 nm enhances the mass adding action, so the spurious component occurring in frequencies higher than the resonant frequency is suppressed.

However, in such a configuration, it is necessary to prepare different mass adding films for the piezoelectric resonators 64 and 65. As a result, the process is complicated, and this results in a high cost.

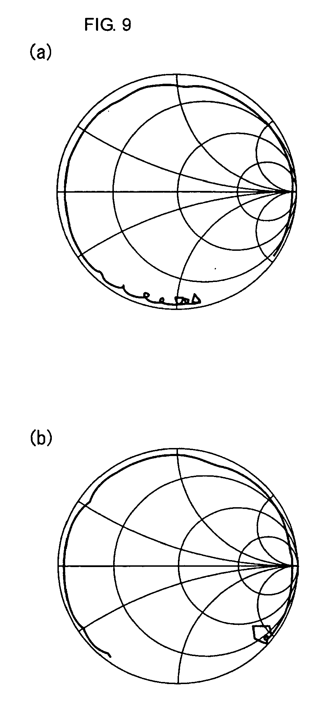

In contrast to this, the piezoelectric filter 1 according to the present embodiment can use the same material and film thickness in the mass adding films 11 and 15 used in the piezoelectric resonators 3 and 4, respectively. This does not result in an increase in the number of steps, as described above, is not incurred. Additionally, a spurious component occurring in frequencies higher than the resonant frequency can be effectively suppressed in the piezoelectric resonator 4. This is described with reference to Figs. 9(a) and 9(b).

The piezoelectric filter 1 was made such that the material and thickness of each thin film portion of the piezoelectric filter 1 were set as shown in Table 3 below.

**TABLE 3**

| Film Thickness (nm) | Resonator 3 | Resonator 4 |
|---|---|---|
| Frequency Adjustment Film | 20 | 20 |
| Mass Adding Film | 320 | 320 |
| Upper Electrode (Al/Ti) | 100/10 | 100/10 |
| Piezoelectric Thin Film (AIN) | 2556 | 2556 |
| Lower Electrode (Pt/Ti/Al/Ti) | 10/10/100/10 | 10/10/205/10 |

The resonant characteristics of the piezoelectric resonators 3 and 4 made in such a way are illustrated in Figs. 9(a) and 9(b) with impedance Smith charts.

As is obvious from Fig. 9(a), it is found that, in both the piezoelectric resonator 3 and the piezoelectric resonator 4, a spurious component is suppressed in frequencies higher than their respective resonant frequencies. The reason for this is described below. That is, in the piezoelectric filter 1, the piezoelectric resonator 3 is optimized, and a spurious component in the piezoelectric resonator 3 is first suppressed. In this case, although a spurious component would be apt to appear in the piezoelectric resonator 4, in the present embodiment, because the lower electrode 13 as the second electrode extends to a location that overlaps the mass adding film 15 in plan view and additionally the film thickness of the lower electrode 13 is larger than that of the upper electrode 12, a sufficient mass adding action can be obtained from the part adjacent to the outer area of the lower electrode 13. Consequently, a spurious component occurring in frequencies higher than the resonant frequency can be effectively suppressed.

In the above embodiment, each of the mass adding films 11 and 15 made of SiO₂ has a thickness of 320 µm. A spurious component appearing in the resonant characteristics can be suppressed by changing the thickness of the mass adding film.

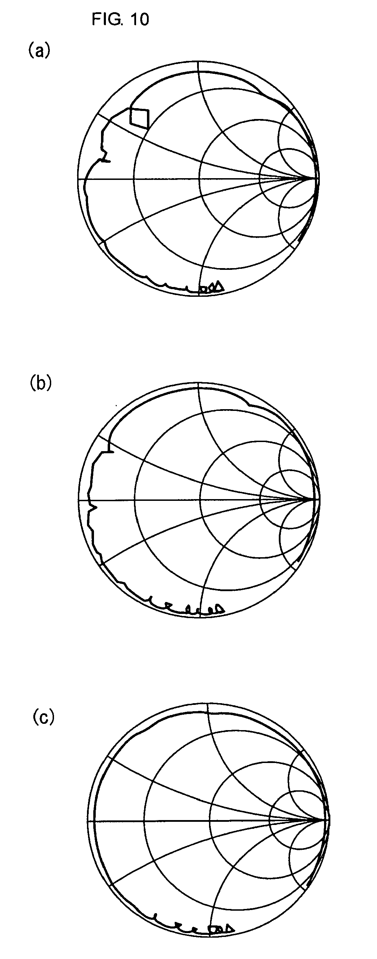

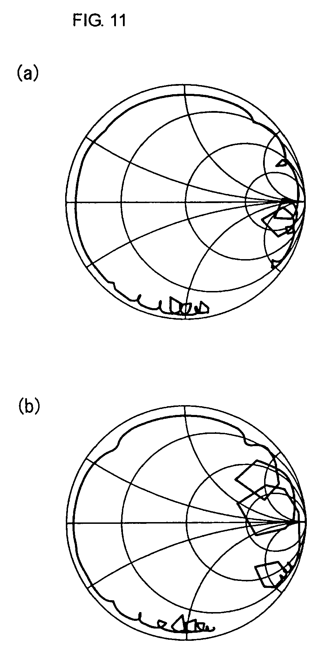

Figs. 10(a) to 10(c) and Figs. 11(a) and 11(b) are Smith charts that illustrate changes in resonant characteristics of the piezoelectric resonator 3 in the first embodiment when the thickness of the mass adding film 11 is changed to 240 nm, 260 nm, 320 nm, 420 nm, and 440 nm, respectively.

As is obvious from Figs. 10 and 11, it is found that the degree of suppression of a spurious component appearing in the resonant characteristics is changed by changing the thickness of the mass adding film 11. In particular, it is found that, when the mass adding film 11 has a thickness of 260 to 420 nm, a spurious component can be effectively suppressed. The reason for this may be that these cases succeed in enabling Lamb waves, which cause a spurious component, to escape to the outside of the vibrating portion without confining them in the vibrating portion.

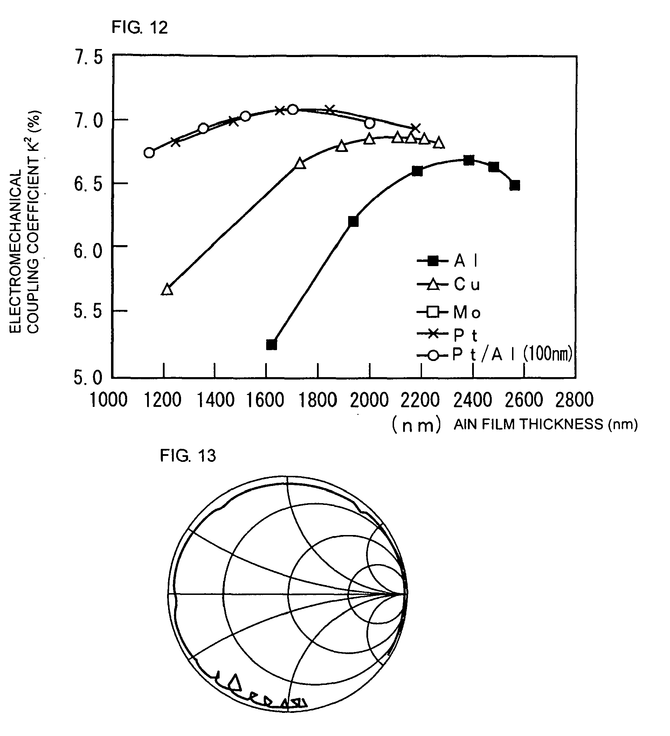

In the above embodiment, as shown in Table 3, a laminated metallic film including an Al layer having a film thickness of 100 nm and a Ti layer having a thickness of 10 nm was used as the upper electrode. A laminated structure in which Pt/Ti/Al/Ti layers have film thicknesses of 10 nm/10 nm/100 nm/10 nm was used as the lower electrode 9. In contrast to this, the inventor et al. of the present invention found that, when the film thickness and material of the AlN film as the piezoelectric thin film and those of the other thin films were set as shown in Table 4 below, more favorable resonant characteristics having no spurious component between the resonant frequency and the anti-resonant frequency was obtainable, as illustrated in the Smith chart in Fig. 13.

**TABLE 4**

| Film Thickness (nm) | Resonator |
|---|---|
| Frequency Adjustment Film SiO₂ | 20 |
| Mass Adding Film AIN | 690 |
| Upper Electrode (Al/Ti/Pt/Ti) | 100/10/80/10 |
| Piezoelectric Thin Film (AIN) | 1690 |
| Lower Electrode (Pt/Ti/Al/Ti) | 80/10/100/10 |

As illustrated in Fig. 12, it is known that, when a piezoelectric film made of AlN is used and the electrode material is Al, copper (Cu), molybdenum (Mo), Pt, or a Pt-Al alloy, the electromechanical coupling coefficient K² changes depending on the film thickness of the AlN film. To obtain a large fractional bandwidth, as is obvious from Fig. 12, it is preferable that an electrode material having a relatively high density, such as Pt, be used. When an electrode material that has a relatively high density is used, the thickness of the piezoelectric thin film can be reduced, so the area of the electrode for obtaining necessary impedance can be reduced. As a result, miniaturization of the piezoelectric resonator and the piezoelectric filter can be advanced.

It is noted that, when the electrode is made of a metal that has a high density, in order to obtain a resonator having high Q and a suppressed spurious component, it is necessary to increase the mass addition to the surrounding area of the piezoelectric vibrating portion.

In contrast to this, in the above embodiment, mass is added to the surrounding area of the piezoelectric vibrating portions by the mass adding films 11 and 15. Additionally, the lower electrodes 9 and 13 extend to the outside of the respective piezoelectric vibrating portions, so a part of the lower electrodes 9 and 13 also adds mass. Therefore, an increase in bandwidth and miniaturization of an element can be accomplished by the use of an electrode material having a high density, such as Pt, in the principle part of the material of the laminated metallic film.

Accordingly, in the present invention, preferably, the upper electrode and the lower electrode, which serve as the first and second electrodes, respectively, be made of an electrode material that contains Pt, which has a relatively high density, as the principal electrode layer. In the above embodiment, the mass adding film is made of SiO₂. However, the mass adding film can also be made of various kinds of dielectric materials or an insulating material, such as AlN or ZnO.

In addition to SiO₂, another suitable dielectric material or insulating material that allows the resonant frequency to be delicately adjusted by the addition of mass can be used in the frequency adjustment film.

In the first embodiment, the piezoelectric filter 1 having the plurality of piezoelectric resonators 3 and 4 is described. As in the piezoelectric resonator 4, the second electrode 13 can have a larger mass adding effect by the use of the lower electrode 13 as the second electrode extending to the outside of the piezoelectric vibrating portion and having a thickness larger than that of the first electrode 12. Therefore, it is pointed out that such a piezoelectric resonator is also one embodiment of the present invention.

Next, one example method of making a piezoelectric resonator according to a modification example of the above embodiment will be described.

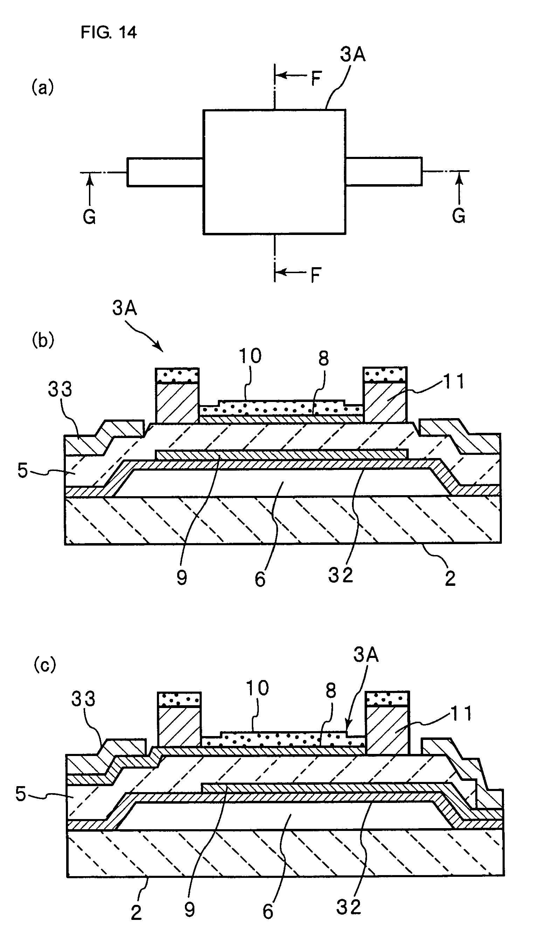

In the above embodiment, as previously described, the piezoelectric resonators 3 and 4 in the piezoelectric filter 1 were formed such that they are separated from the substrate 2 with the cavities 6 and 7 disposed therebetween, respectively. One example method of making such a piezoelectric resonator using a readily solvent-removable material is previously described. A more specific making method is described below with reference to Figs. 14 to 17.

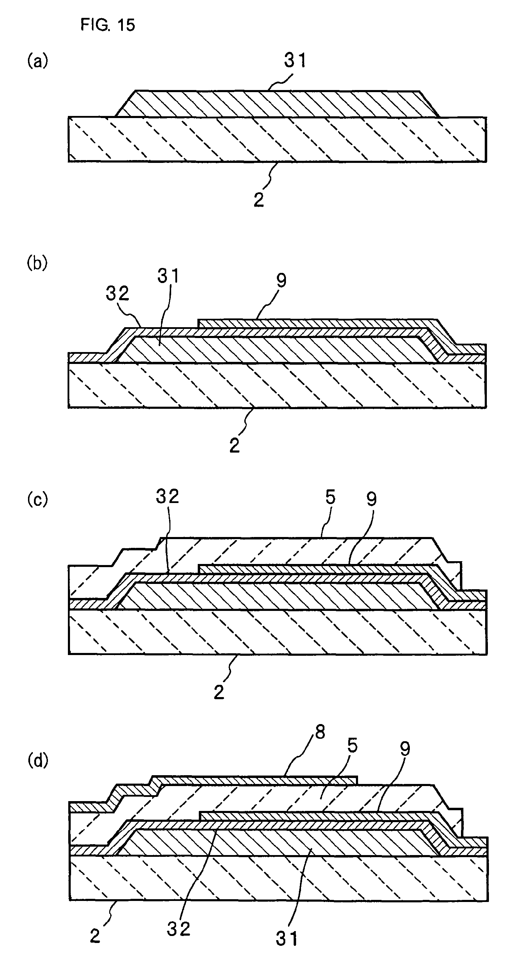

In the present modification example, the main part of a piezoelectric resonator 3A is illustrated in Fig. 14(a) with a schematic plan view. Figs. 14(b) and 14(c) are cross-sectional views taken along the line F-F and line G-G in Fig. 14(a), respectively. In the piezoelectric resonator 3A according to the present modification example, the piezoelectric resonator part composed of a laminated thin film is separated from the substrate 2 with the cavity 6 disposed therebetween, as in the case of the piezoelectric resonator 3 according to the first embodiment. A method of making the piezoelectric resonator 3A is described below with reference to Figs. 15 to 17.

First, as illustrated in Fig. 15(a), a zinc oxide (ZnO) sacrificial layer 31 made of ZnO as a material for forming a cavity is formed on the substrate 2. The ZnO sacrificial layer 31 can be formed by a suitable method, for example, by wet etching. In the present modification example, the ZnO sacrificial layer 31 was formed by wet etching so as to have a thickness of 100 nm.

Then, as illustrated in Fig. 15(b), a protective layer 32 as the primer layer was formed so as to cover the ZnO sacrificial layer 31. The protective layer 32 was formed by a thin-film forming method such that a SiO₂ film had a thickness of 100 nm.

After that, a laminated metallic film of Ti, Pt, Au, Pt, and Ti layers having thicknesses of 10, 30, 60, 10, and 10 nm was formed on the protective layer 32. After that, the laminated metallic film was subjected to patterning by photolithography, thus forming the lower electrode 9.

Then, the piezoelectric thin film made of AlN was formed by sputtering so as to have a thickness of 1584 nm. As illustrated in Fig. 15(c), the piezoelectric thin film was subjected to patterning, and a part of the lower electrode 9 was exposed. In such a way, the piezoelectric thin film 5 was formed.

After that, as illustrated in Fig. 15(d), the upper electrode 8 was formed on the piezoelectric thin film 5. The upper electrode 8 was formed by laminating metallic layers of Ti, Pt, Au, Pt, and Ti layers having thicknesses of 10, 10, 60, 30, and 10 nm, respectively, by sputtering and then subjecting the laminated structure to patterning by the lift-off technique.

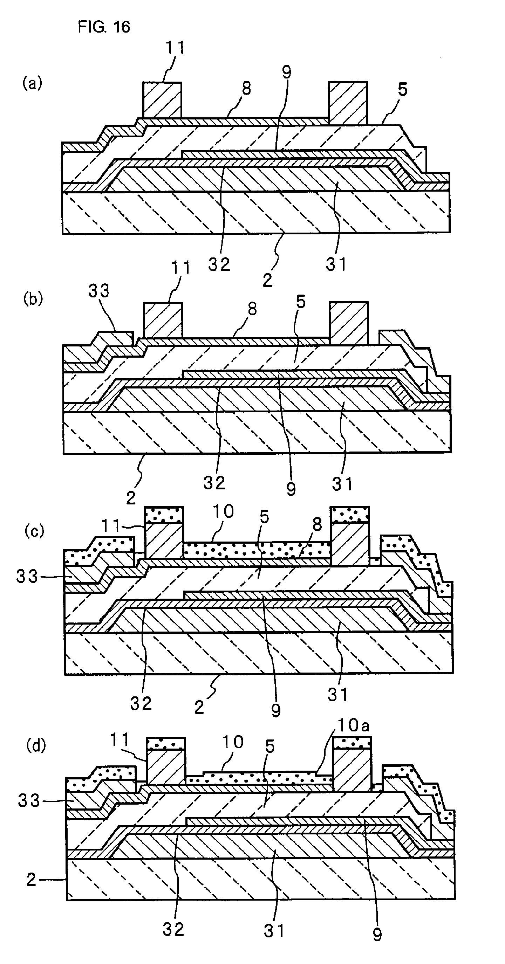

After that, as illustrated in Fig. 16(a), the mass adding film 11 made of AlN was formed on the surrounding area of the piezoelectric vibrating portion on the piezoelectric thin film 5 so as to have a thickness of 680 nm and subjected to patterning, so the mass adding film 11 was formed.

Then, as illustrated in Fig. 16(b), a thick-film electrode 33 was formed by depositing Cu so as to be electrically connected to the upper electrode 8. The thickness of the thick-film electrode 33 was 500 nm.

Then, as illustrated in Fig. 16(c), the frequency adjustment film 10 made of SiO₂ was formed on the entire upper surface so as to have a thickness of 100 nm.

Then, as illustrated in Fig. 16(d), the upper surface of the frequency adjustment film 10 was subjected to dry etching, thus forming a step 10a. That is, the outer-edge portion of the frequency adjustment film 10 was polished by dry etching so as to reduce its thickness by 20 nm.

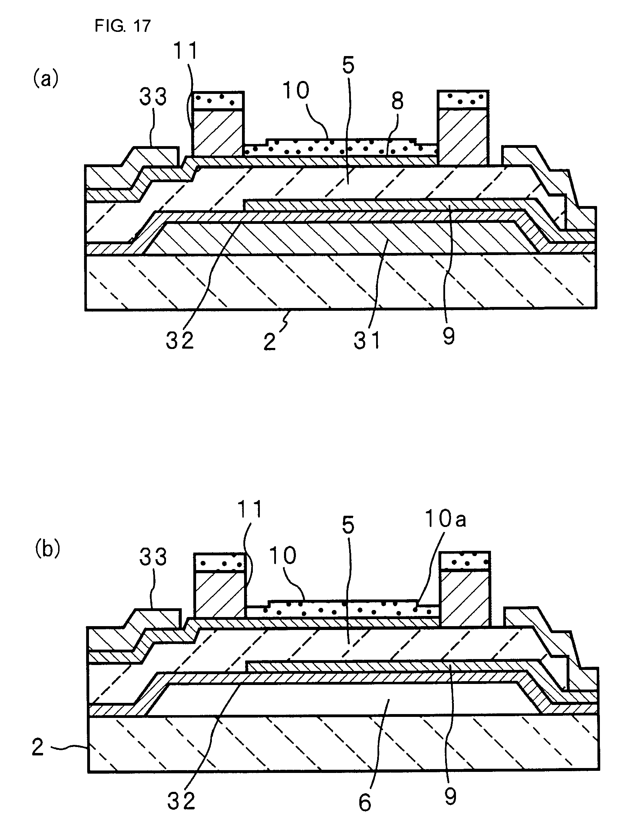

After that, as illustrated in Fig. 17(a), an electrode pad 23 was formed, and thereafter, the SiO₂ film was removed by dry etching at the surrounding area of the mass adding film 11. As illustrated in Fig. 17(b), the ZnO sacrificial layer 31 was removed by wet etching, thus forming the cavity 6.

In such a way, the piezoelectric resonator 3A illustrated in Figs. 14(a) to 14(c) was made.

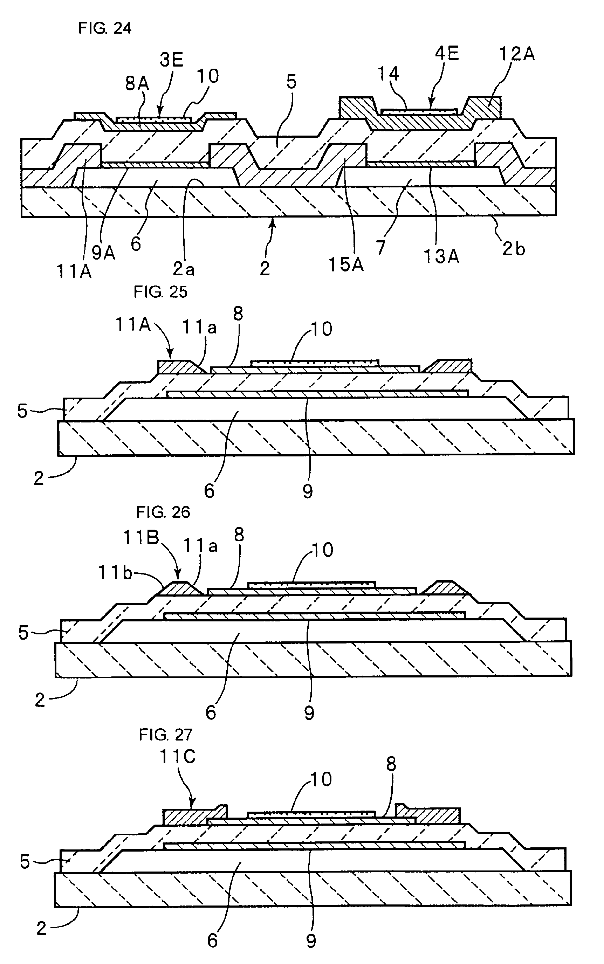

Piezoelectric resonators according to other modification examples of the above embodiment are shown in Figs. 25 to 36.

In Figs. 25 to 36, the same reference numerals are used as in the configuration of the piezoelectric resonator illustrated in Figs. 14(a) to 14(c) for the same parts, thereby omitting the detailed description thereof.

For the piezoelectric resonator illustrated in Fig. 25, a mass adding film 11A includes an inclined portion 11a. The inclined portion 11a in the mass adding film 11A is inclined toward the part where the upper electrode 8 and the lower electrode 9 face each other such that the thickness of the mass adding film 11A becomes smaller.

For the piezoelectric resonator illustrated in Fig. 26, a mass adding film 11B further includes an inclined portion 11b, in addition to the inclined portion 11a. The inclined portion 11b gradually becomes thinner toward the edge being opposite the piezoelectric vibrating portion.

The provision of the inclined portion 11a or the provision of the inclined portions 11a and 11b gently changes the mass adding effect in the inclined portion(s) with a distance from the piezoelectric vibrating portion. Because of this, even if misregistration occurs in the photolithographic process or etching process in forming the mass adding film 11A or 11B, changes in characteristics can be reduced. This can improve yields of products.

As in a modification example illustrated in Fig. 27, a part of a mass adding film 11C may extend to the piezoelectric vibrating portion, where the upper electrode 8 and the lower electrode 9 faces each other. Here, a part of the mass adding film 11C extends to a part of the upper surface of the upper electrode 8, which normally has a smaller size. When the mass adding film 11C is formed so as to extend to the piezoelectric vibrating portion, as described above, unnecessary vibration to be suppressed by the mass adding film 11C is apt to propagate to the mass adding film 11C. Even if misregistration occurs in the formed position of the mass adding film 11C in the photolithographic process or etching process in forming the mass adding film 11C, changes in characteristics are less prone to being produced.

When a piezoelectric resonator in the 2 GHz range is designed, the width of a portion where the mass adding film 11C overlaps the piezoelectric vibrating portion may preferably be approximately 5 µm or less. The width of this overlapping portion is inversely proportional to a designed frequency for the thickness longitudinal vibration to be divided to the piezoelectric resonator. On the other hand, when the mass adding film is formed away from the piezoelectric vibrating portion, the distance between the mass adding film and the piezoelectric vibrating portion may preferably be approximately 1 µm or less. This distance is also inversely proportional to a designed frequency for the thickness longitudinal vibration.

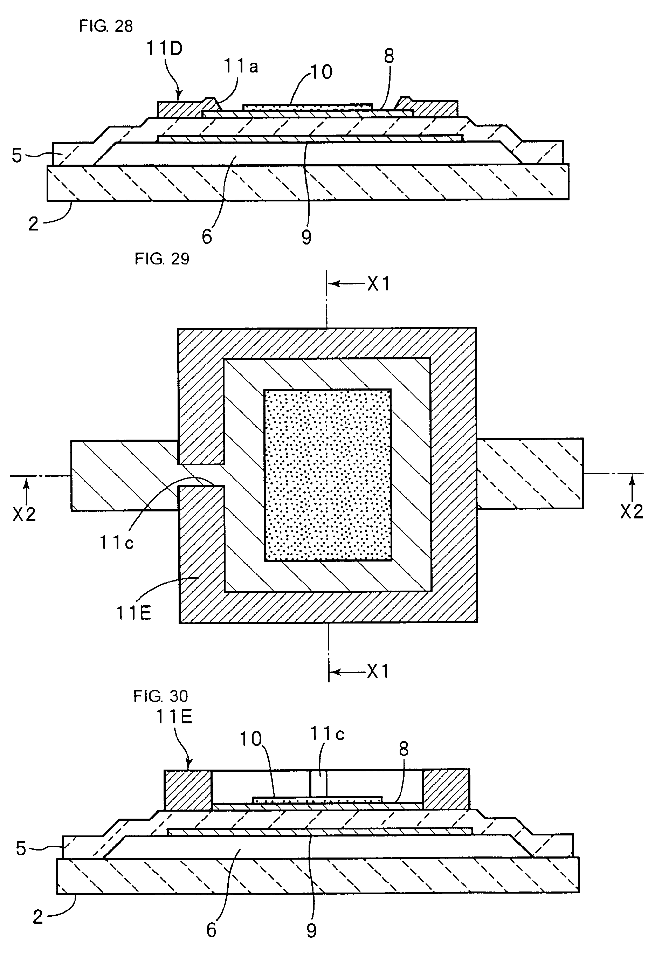

As in a modification example illustrated in Fig. 28, a mass adding film 11D extending to the piezoelectric vibrating portion may further include the inclined portion 11a.

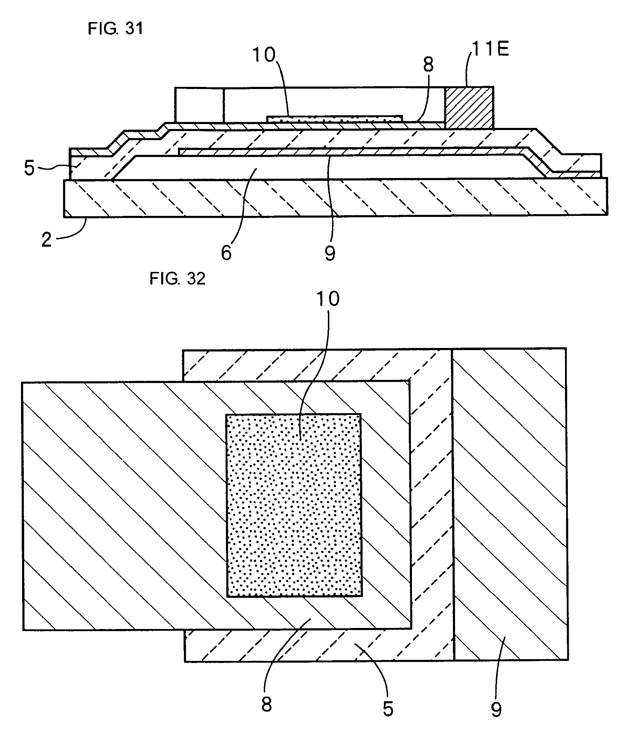

Fig. 29 is a plan view for describing a piezoelectric resonator according to yet another modification example of the above embodiment. Fig. 30 is a cross-sectional view taken along the line X1-X1 in Fig. 29. Fig. 31 is a cross-sectional view taken along the line X2-X2 in Fig. 29.

For the piezoelectric resonator according to the present modification example, a mass adding film 11E surrounding the piezoelectric vibrating portion and having a rectangular-frame shape may include a cut 11c. In this case, when the lift-off technique is used in forming the mass adding film 11E, a solution for dissolving the photoresist is easy to enter the inside of the region where the mass adding film 11E is formed, so lift-off can be readily performed. Accordingly, the manufacturing process can be simplified.

For the piezoelectric resonator illustrated in Fig. 14 or Fig. 29, although the upper electrode 8 and the lower electrode 9 overlap each other in the piezoelectric vibrating portion, the dimension in the width direction of a part of the upper electrode 8 or the lower electrode 9 drawn out of the piezoelectric vibrating portion is smaller than the width of the upper electrode 8 or the lower electrode 9 present in the piezoelectric vibrating portion. However, as illustrated in Fig. 32, the upper electrode 8 and the lower electrode 9 overlapping each other in the piezoelectric vibrating portion may be drawn out of the piezoelectric vibrating portion to the outside without changing its width. In this case, the wiring width can be larger, so the wiring resistance can be reduced. Fig. 32 is a schematic plan view of the piezoelectric resonator according to such a modification example.

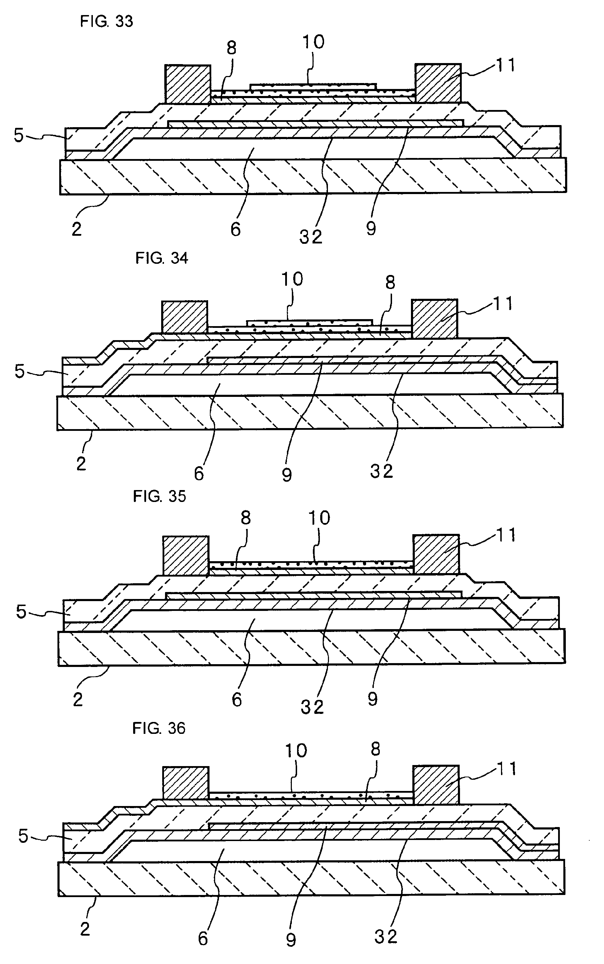

Figs. 33 and 34 are a schematic partial front view and a side cross-sectional view, respectively, that illustrate a piezoelectric resonator according to still another modification example of the present invention. For the piezoelectric resonator according to the modification example illustrated in Fig. 33, the film thickness and material of each of the frequency adjustment film, the mass adding film, the upper electrode, the piezoelectric thin film, and the lower electrode are formed as illustrated in Table 5 below. That is, here, the piezoelectric thin film 5 is made of AlN and is formed thin, a thickness of 1135 nm, whereas each of the upper electrode 8 and the lower electrode 9 is composed of a laminated metallic film illustrated in Table 5 below and formed relatively thick. Forming the piezoelectric thin film composed of such a thin AlN film accomplishes a further reduction in thickness of the piezoelectric resonator.

**TABLE 5**

| Film Thickness (nm) | Resonator A |
|---|---|
| Frequency Adjustment Film SiO₂ | 20+80 (100 nm with the outer-edge portion being thinned by 20 nm) |
| Adding Film AIN | 900 |
| Upper Electrode (Ti/Pt/Au/Pt/Ti) | 10/10/80/70/10 |
| AIN | 1135 |
| Lower Electrode (Ti/Pt/Au/Pt/Ti) | 10/70/80/10/10 |
| SiO₂ | 100 |

Figs. 35 and 36 are a partially broken, front, cross-sectional view and a side cross-sectional view, respectively, that illustrate a piezoelectric resonator according to still another modification example of the modification example illustrated in Figs. 33 and 34. Here, in contrast to Figs. 33 and 34, the SiO₂ film as the frequency adjustment film is composed of a single layer, so it does not have a double-layer structure having no step. That is, as illustrated in Table 5, for the configuration illustrated in Figs. 33 and 34, after the SiO₂ film having a thickness of 100 nm was formed, the outer-edge portion was thinned by 20 nm, so a step was provided to the frequency adjustment film. In contrast to this, as illustrated in Figs. 35 and 36, the frequency adjustment film may have no step by the use of formation of the SiO₂ film having a thickness of 100 nm. The piezoelectric resonator illustrated in Figs. 35 and 36 is formed using the settings illustrated in Table 5 as the material and thickness, except the above frequency adjustment film. Also in this case, because the piezoelectric thin film is formed thin, a reduction in thickness of the piezoelectric resonator can be accomplished. Additionally, because it is not necessary to thin the outer edge of the SiO₂ film as the frequency adjustment film, the process can be reduced, so the cost can be cut.

Note that a method of making a piezoelectric resonator is not limited to the above-described making method.

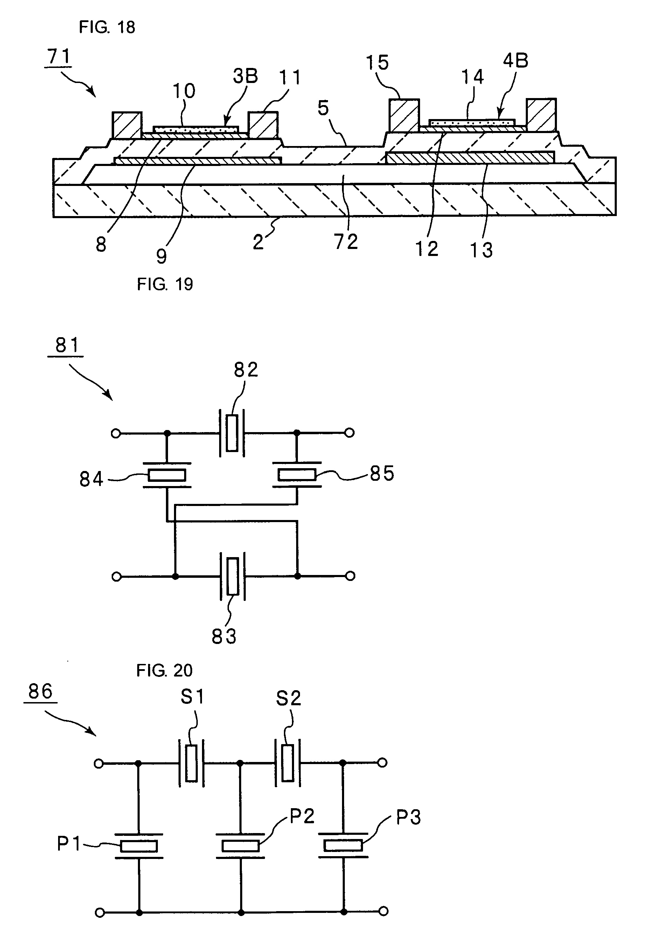

Fig. 18 is a schematic front cross-sectional view of a piezoelectric filter according to a second embodiment of the present invention. For a piezoelectric filter 71 according to the second embodiment, piezoelectric resonators 3B and 4B are formed using the same substrate 2. The piezoelectric filter 71 differs from the piezoelectric filter 1 according to the first embodiment in that the cavities, 6 and 7 in the first embodiment, are linked together. That is, the piezoelectric thin film 5 is separately disposed over the entire region where the piezoelectric resonators 3B and 4B are formed, with a cavity 72 disposed therebetween. In such a manner, the plurality of piezoelectric resonators 3B and 4B may be separated from the substrate 2 with the common cavity 72 disposed therebetween. The other configuration of the piezoelectric filter 71 is substantially the same as in the piezoelectric filter 1.

In the first embodiment, the piezoelectric resonators 3 and 4 being electrically connected to each other to form a ladder circuit are described. In a filter device according to the present invention, the plurality of piezoelectric resonators can be electrically connected to form various filter circuits. One such example filter circuit is illustrated in Fig. 19. Fig. 19 is a circuit diagram of a filter device having a lattice circuit configuration.

A lattice filter 81, which is illustrated in this drawing, can be connected to other lattice filters 81. This can enhance the steepness of the filter characteristics and attenuation characteristics.

Fig. 20 is a circuit diagram of one example of a ladder filter circuit.

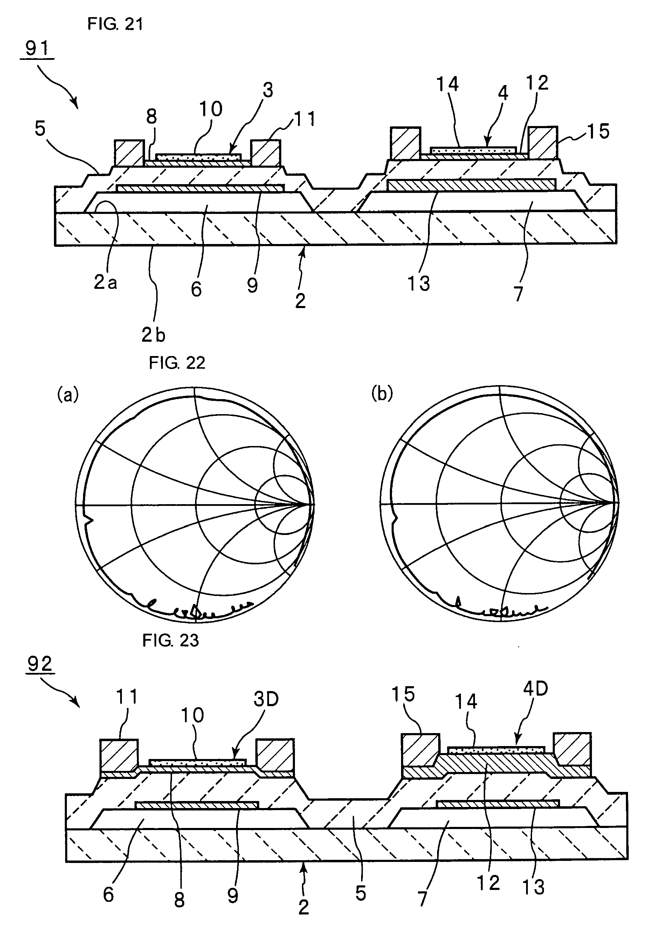

Fig. 21 is a schematic front cross-sectional view of a piezoelectric filter according to a third embodiment of the present invention. A piezoelectric filter 91 has substantially the same configuration as in the piezoelectric filter 1. Therefore, the same reference numerals are used as in the piezoelectric filter 1 for the same parts, thereby omitting the detailed description thereof. For the piezoelectric filter 91, the material and the film thickness of each of the piezoelectric resonators 3 and 4 are set as shown in Table 6 below.

**TABLE 6**

| Film Thickness (nm) | Resonator 3 | Resonator 4 |
|---|---|---|
| Frequency Adjustment Film SiO₂ | 20 | 20 |
| Mass Adding Film SiO₂ | 320 | 320 |
| Upper Electrode (Al/Ti) | 100/10 | 100/10 |
| Piezoelectric Thin Film (AlN) | 2140 | 2140 |
| Lower Electrode (Pt/Ti) | 100/10 | 121/10 |

The resonant frequency of the piezoelectric resonator 3 is set at 1882 MHz and the anti-resonant frequency thereof is set at 1936 MHz. The resonant frequency of the piezoelectric resonator 4 is set at 1821 MHz and the anti-resonant frequency thereof is set at 1873 MHz.

The resonant characteristics of the piezoelectric resonator 3 and those of the piezoelectric resonator 4 in the piezoelectric filter 91 according to the third embodiment are shown in Figs. 22(a) and 22(b) with Smith charts, respectively.

As is obvious from Figs. 22, it is found that a spurious component can be effectively suppressed in a range higher than the resonant frequency.

In the present embodiment, because the lower electrodes 9 and 13 are formed using an electrode material that has a higher density, compared with the first embodiment, the area of the piezoelectric vibrating portion can be reduced by 16%. This enables miniaturization.

Fig. 23 is a schematic front cross-sectional view of a piezoelectric filter according to a fourth embodiment of the present invention. As illustrated in Fig. 23, for a piezoelectric filter 92 according to the present embodiment, in piezoelectric resonators 3D and 4D, the upper electrodes 8 and 12 exceed beyond the respective piezoelectric vibrating portions to regions that overlap the mass adding films 11 and 15, respectively, in plan view. In the piezoelectric resonator 4D, the upper electrode 12 is thicker than the lower electrode 13. The lower electrodes 9 and 13 are disposed in the respective piezoelectric vibrating portions and smaller than the upper electrodes 8 and 12.

That is, in the piezoelectric filter 71 according to the present embodiment, the second electrode having a larger size corresponds to the upper electrodes 8 and 12, whereas the first electrode being smaller corresponds to the lower electrodes 9 and 13.

As described above, in the present invention, each of the electrode formed on the upper surface of the piezoelectric thin film and the electrode formed on the lower surface thereof may be the first electrode or the second electrode.

Also in the piezoelectric filter 71, because the upper electrodes 8 and 12 as the second electrode extend to the outside of the respective piezoelectric vibrating portions, and the upper electrode 12 has a larger thickness in the piezoelectric resonator 4D, a sufficient mass adding effect is obtainable and an undesired spurious component occurring in a range higher than the resonant frequency can be effectively suppressed, as in the first embodiment.

Fig. 24 is a schematic cross-sectional view of a piezoelectric filter according to still another modification example of the present invention. Here, piezoelectric vibrating portions 3E and 4E are formed such that the piezoelectric thin film 5 is separated from and the substrate 2 with the cavities 6 and 7 disposed therebetween. It is noted that the piezoelectric thin film 5 itself is not fixed on the substrate 2 and mass adding films 11A and 15A disposed around the respective piezoelectric vibrating portions are fixed on the upper surface 2a of the substrate 2 outside the piezoelectric vibrating portions. That is, in the piezoelectric vibrating portion 3E, an upper electrode 8A as the second electrode is formed on the upper surface of the piezoelectric thin film 5, and a lower electrode 9A as the first electrode and being smaller is formed on the lower surface thereof. The mass adding film 11 is formed on the lower surface of the piezoelectric thin film 5 around the piezoelectric vibrating portion. The mass adding film 11 extends from the surrounding area of the piezoelectric vibrating portion further to the outer part and is fixed on the upper surface 2a of the substrate 2.

The frequency adjustment film 10 is disposed on the upper surface of the upper electrode 8A.

Similarly, also in the piezoelectric resonator 4E, an upper electrode 12A as the second electrode and being larger is formed on the upper surface of the piezoelectric thin film 5, and the frequency adjustment film 14 is formed on the upper electrode 12A. A lower electrode 13A as the first electrode and being smaller is formed on the lower surface of the piezoelectric thin film 5. The mass adding film 15A disposed around the lower electrode 13A is positioned from the surrounding area of the piezoelectric vibrating portion further to the outside thereof and linked to the mass adding film 11A.

As in the present modification example, the mass adding film may be arranged on the lower-surface side of the piezoelectric thin film included in the piezoelectric resonator. In this case, the laminated thin film containing the piezoelectric thin film may be fixed on the substrate 2 utilizing the mass adding film. The larger second electrode may be formed on either of the upper surface and the lower surface.

## Claims

1. A piezoelectric resonator comprising:
a substrate including first and second main surfaces; and
a laminated thin film including a first thin film portion and a second thin film portion, the first thin film portion being fixed on the first main surface of the substrate and supported by the substrate, the second thin film portion being separated from the first main surface of the substrate and acoustically isolated,
wherein the second thin film portion of the laminated thin film includes a piezoelectric thin film, a first electrode disposed on one main surface of the piezoelectric thin film, and a second electrode disposed on another main surface of the piezoelectric thin film and being larger than the first electrode, and a part where the first and second electrodes overlap each other with the piezoelectric thin film disposed therebetween constitutes a piezoelectric vibrating portion,
the piezoelectric resonator further comprising:
a mass adding film disposed around the first electrode and on at least one part of an outer region linked to a periphery of the piezoelectric vibrating portion,
wherein the second electrode is formed, in plan view, so as to extend beyond the piezoelectric vibrating portion to a region at which the mass adding film is disposed.

2. The piezoelectric resonator according to Claim 1, further comprising a step forming film disposed on the first electrode and disposed within the periphery of the piezoelectric vibrating portion with a gap.

3. The piezoelectric resonator according to Claim 1 or 2, wherein the first electrode and the second electrode have different film thicknesses.

4. The piezoelectric resonator according to Claim 3, wherein the second electrode has a film thickness larger than that of the first electrode.

5. A piezoelectric filter comprising a plurality of piezoelectric resonators according to any one of Claims 1 to 4 fabricated on the same substrate, wherein the plurality of piezoelectric resonators are electrically connected together and constitute a filter circuit.

6. The piezoelectric filter according to Claim 5, wherein at least one piezoelectric resonator of the plurality of piezoelectric resonators is fabricated differently from the other piezoelectric resonators.

7. The piezoelectric filter according to Claim 6, wherein the second electrode of the at least one piezoelectric resonator has a film thickness different from that of the second electrode of each of the other piezoelectric resonators, thereby causing a resonant frequency of the at least one piezoelectric resonator to differ from a resonant frequency of each of the other piezoelectric resonators.

8. The piezoelectric filter according to any one of Claims 5 to 7, wherein, in the at least one piezoelectric resonator of the plurality of piezoelectric resonators, the first electrode and the second electrode have different film thicknesses.

9. The piezoelectric filter according to Claim 8, wherein, in the at least one piezoelectric resonator of the plurality of piezoelectric resonators, the second electrode has a film thickness larger than that of the first electrode.
